# EUROPEAN PATENT APPLICATION

(11) **EP 1 170 791 A2**
(43) Date of publication of application: **09.01.2002**
(21) Application number: 01114349.2
(22) Date of filing: 13.06.2001
(51) Int. Cl.: H01L 21/768

(54) **Semiconductor device with multilayer wiring structure of laminated damascene wiring and fabrication method thereof**

(30) Priority: 14.06.2000 JP 2000178684
(71) Applicant: NEC CORPORATION, Tokyo (JP)
(72) Inventor: Oda, Noriaki, NEC Corporation, Tokyo (JP); Takewaki, Toshiyuki, NEC Corporation, Tokyo (JP); Matsubara, Yoshihisa, NEC Corporation, Tokyo (JP); Iguchi, Manabu, NEC Corporation, Tokyo (JP)
(74) Representative: Glawe, Delfs, Moll & Partner

(57) **Abstract**

A silicon nitride film and a silicon oxide film are formed, and, using an overlying resist film as a mask, are subjected to dry etching to form via-holes. The silicon nitride film is subjected to dry etching to expose the surface of a copper film and the resist residue is removed. A tungsten film is then formed to bury the via-holes with tungsten. Excess tungsten film is removed by CMP and rinsing, thereby forming via-plugs that are composed of the tungsten film that remains in the via-holes. Silicon oxide film is formed over this structure. Using a resist film as a mask, wiring trenches are formed in the silicon oxide film. The resist film and etching residue are then removed. Amine removing solution that has entered seams in the tungsten film is vaporized by a heat treatment. A copper film is embedded in the wiring trenches by a damascene method, thereby forming damascene copper wiring.

## Description

### Background of the Invention:

### 1. Field of the Invention:

The present invention relates to a semiconductor device that is provided with a multilayer wiring structure with laminated damascene wiring, and to a method of fabricating such a semiconductor device.

### 2. Description of the Related Art:

The demand for increased integration and higher speeds of semiconductor devices in recent years has resulted in the widespread use of semiconductor elements that are provided with a multilayer wiring structure. In this type of semiconductor element, copper is sometimes used as the wiring material and a construction is adopted in which copper wiring is connected by contact holes and via-holes.

Materials such as tungsten and copper are used for filling these contact holes and via-holes. After a film of the conductive material is formed by CVD (Chemical Vapor Deposition) or plating, the film is planarized by, for example, CMP (Chemical Mechanical Polishing), whereby the conductive film is embedded inside the holes to form via-plugs.

When a via-plug is formed by proceeding through the above-described processes, however, a cavity referred to as a "seam" occurs at the center line of the plug, and this cavity can cause various problems in processing. This point will be explained below using a method of the prior art for fabricating a tungsten plug as an example.

Referring now to Figs. 1A-5B, the prior-art method will be described. First, damascene copper wiring is formed as shown in Fig. 1A.

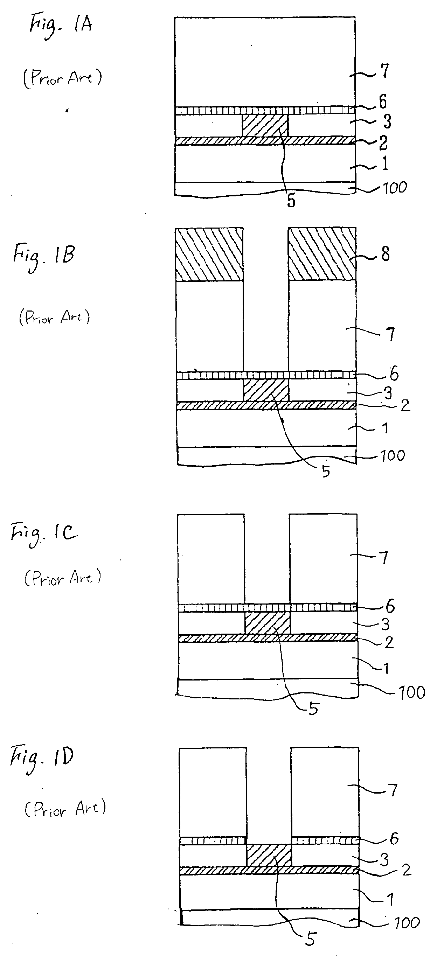

Specifically, silicon oxide film 1, silicon oxynitride film 2, and silicon oxide film 3 are formed by a plasma CVD method on a semiconductor substrate 100 on which, for example, transistors (not shown in the figure) are formed. Copper film 5 is then embedded in silicon oxide film 3 by a known damascene method to form copper wiring. Silicon nitride film 6 and silicon oxide film 7 are then formed on this structure by, for example, plasma CVD.
Resist film 8 having a prescribed opening is next provided on silicon oxide film 7. Using this film as a mask, silicon oxide film 7 is then subjected to dry etching to form a via-hole that reaches silicon nitride film 6 (Fig. 1B). Oxygen plasma ashing is then carried out to remove resist film 8. The resist residue that adheres to the surface of silicon oxide film 7 and the inner walls of the hole is then removed by a resist removing solution (Fig. 1C). Silicon nitride film 6 is then subjected to dry etching to expose the surface of wiring film 5. The resist residue is then removed by a resist removing solution (Fig. 1D).

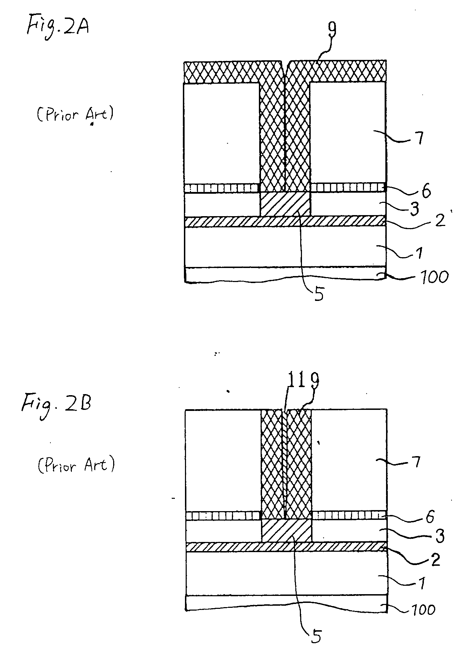

An adhesive film (not shown in the figure) is then formed over the entire surface of silicon oxide film 7, and tungsten film 9 is formed over this adhesive film using CVD (Fig. 2A). After forming tungsten film 9, the film is planarized using CMP processing solution 11 to form tungsten film 9 inside the via-hole (Fig. 2B). At this time, a seam occurs within tungsten film 9. The mechanism of the occurrence of this seam will be next briefly explained.

In the process of growing the tungsten shown in Fig. 2A, the thickness of the tungsten film that adheres to the inner walls of the via-hole is thin in the initial stages of the film growth, and film growth proceeds smoothly because the inside of the hole can be easily supplied with the material gas. As tungsten film 9 becomes more thickly deposited on the inner walls of the hole, however, the space in the hole gradually shrinks, and the supply of the material gas to the hole interior is impeded. The rate of film growth of tungsten film 9 inside the hole decreases as the space inside the hole shrinks, and the rate of film growth is considered to approach 0 in the final stages of the embedding, whereby the cavity that is referred to as a seam occurs in tungsten film 9. Owing to the above-described mechanism of their occurrence, many seams occur particularly when forming plugs having a high aspect ratio.

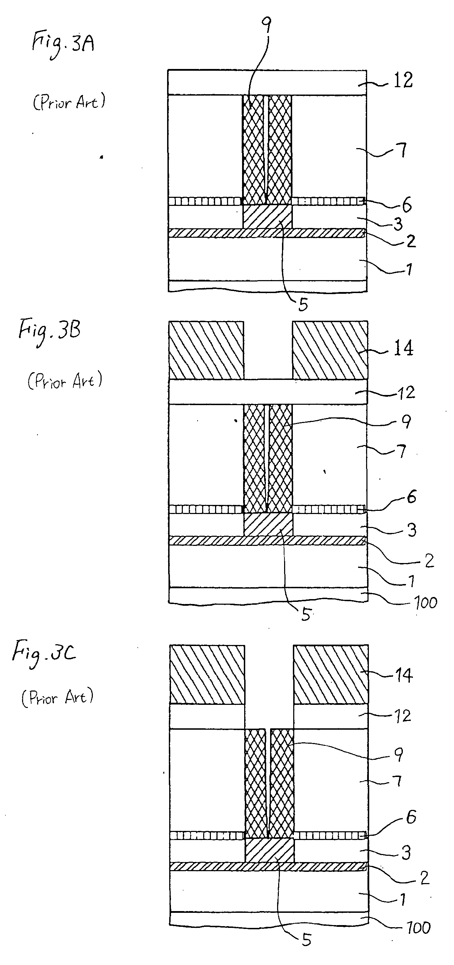

After CMP and cleaning of tungsten film 9, silicon oxide film 12 is formed on tungsten film 9 by a CVD method (Fig. 3A). Resist film 14 having a prescribed opening is then provided (Fig. 3B). Using this resist film 14 as a mask, a wiring trench is formed in silicon oxide film 12 (Fig. 3C).

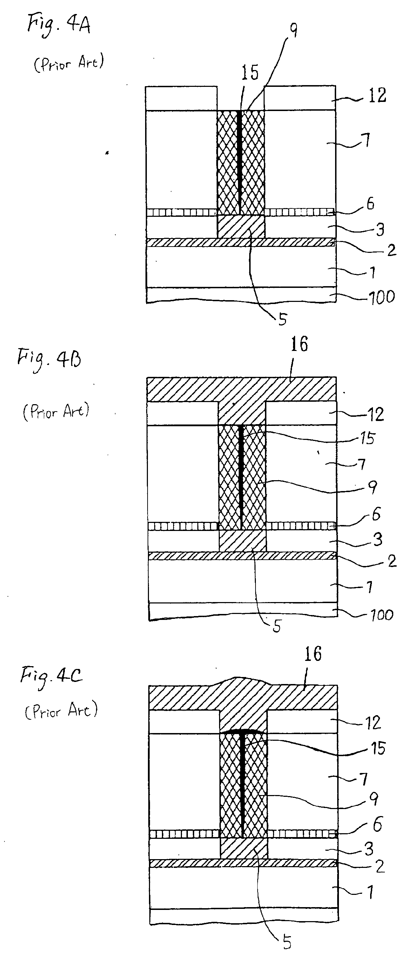

An oxygen plasma ashing process and a stripping process using removing solution are carried out to remove resist film 14 and etching residue. At this time, removing solution 15 penetrates the seam in the tungsten film as shown in Fig. 4A.

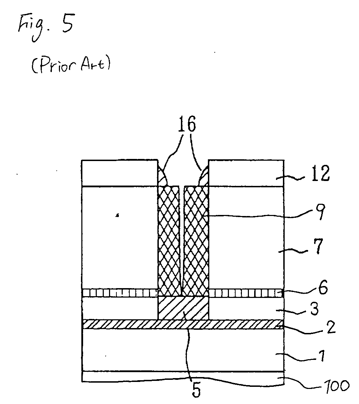

Copper film 16 is then formed over the entire surface (Fig. 4B), and during the film formation or the subsequent annealing process, removing solution 15 vaporizes, expands in volume, and causes a blister in copper film 16 (Fig. 4C). This results in various problems, such as peeling of copper film 16 from the wiring trench when subsequently planarizing by means of CMP as shown in Fig. 5, resulting in damage to the wiring structure and an increase in wiring resistance.

Liquid that remains in the seam leads to various problems other than blistering and peeling of the film as described hereinabove, and another example of the prior art is taken as an example to further explain this point.

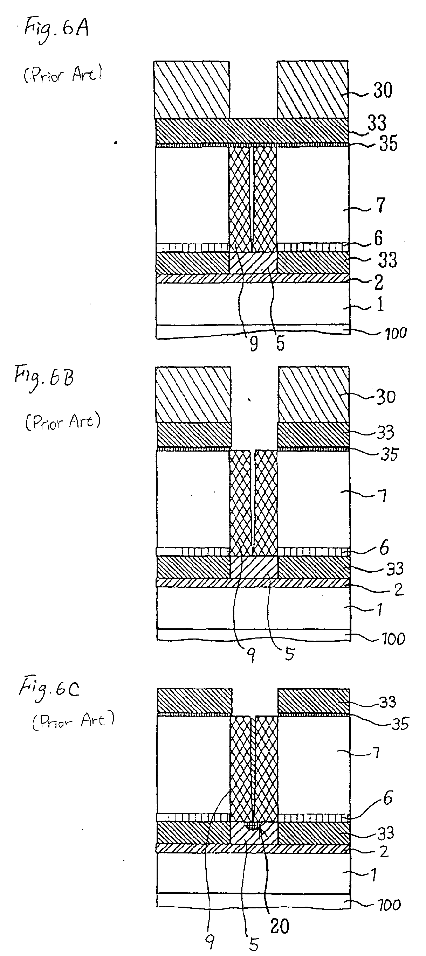

Figs. 6A-8B show the steps of forming a plug according to a second example of the prior art. First, as shown in Fig. 6A, a wiring structure is formed in which a tungsten plug is provided between copper wiring.

Specifically, silicon oxide film 1 and silicon oxynitride film 2 are first formed by plasma CVD. HSQ (hydrogen silisesquioxane) film 33 is then formed by a rotational application method, following which copper film 5 is embedded in HSQ film 33 by a known damascene method to form copper wiring. Silicon nitride film 6 and silicon oxide film 7 are then formed over copper layer 5 and HSQ film 33 by a plasma CVD method. A via-plug composed of tungsten film 9 is then formed by the same procedure as in the first example of the prior art. Silicon oxynitride film 35 and HSQ film 33 are then formed over tungsten film 9. Finally, resist film 30 having a prescribed opening is provided over silicon oxynitride film 35 and HSQ film 33. Fig. 6A shows the state following completion of the above-described processes.

Next, an opening is formed in HSQ 33 and silicon oxynitride film 35 by dry etching to expose tungsten film 9 (Fig. 6B). Ashing and a stripping process using a resist removing solution are then carried out to remove resist 30. In this case, a solution having a strong removing action such as ammonium fluoride is used as the removing solution. The removing solution is selected as appropriate according to processing conditions such as the ashing conditions, the material to be etched in the etching of wiring trenches, and the etching gas. When prevention of damage to the conductive film takes precedence, a low-corrosion amine removing solution containing corrosion inhibitors is used, as in the first example of the prior art. However, in a case in which resist residue must be completely removed or in which deposits (etching deposits) that occur on resist side walls or inside wiring trenches due to etching must be effectively eliminated, a removing solution having strong removing action such as ammonium fluoride is used. In the second example of the prior art, this latter viewpoint directs the use of an ammonium fluoride removing solution.

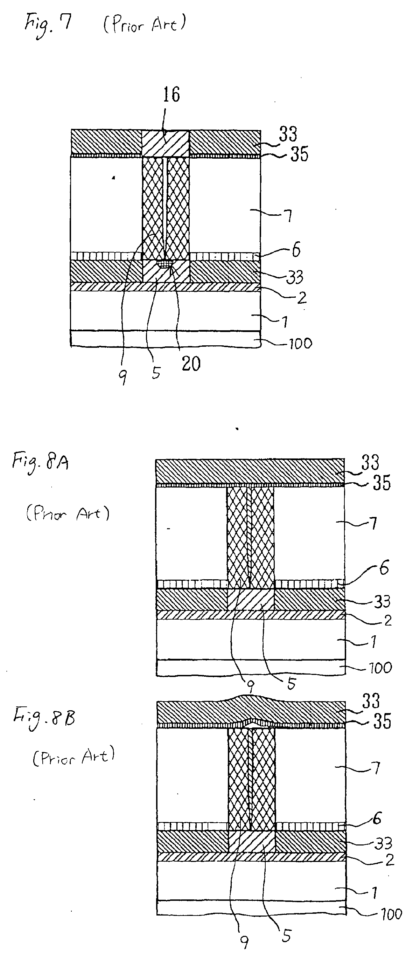

In cases of using the strong removing solution, however, corrosion of copper is also strong, and penetration of the removing solution into a seam results in corrosion of a portion of copper film 5 (Fig. 6C). Fig. 7 shows the subsequent state of completion of the upper copper wiring by forming copper film 16. In this type of wiring structure, metal corrosion area 20 results in an increase in contact resistance and wiring resistance and a large-scale reduction of element characteristics. A removing solution having low corrosion against metal may be used to suppress the occurrence of metal corrosion area 20 as previously described, but some processes compel the use of a strong removing solution to remove etching deposits. In such cases, an effective means of avoiding the above-described problem of corrosion has yet to be found.

Furthermore, in the above-described second example of the prior art, CMP process solution 11 that remains in the seam that occurs in tungsten film 9 (Fig. 8A) may result in a blister in the film during the process of heating and curing HSQ film 33 after forming silicon oxynitride film 35 and HSQ film 33 as shown in Fig. 8B. CMP processing solution 11 in a seam may vaporize and thus become removable when forming silicon oxynitride film 35, but removing the remaining liquid for all via-plugs that are formed on a wafer is problematic. In particular, depending on the conditions of film formation, silicon oxynitride film 35 may be formed before all remaining liquid is eliminated, and the above-described problem becomes conspicuous.

As described in the foregoing explanation, when a seam occurred in a tungsten plug, various liquids that are used in subsequent processes were able to enter the seam, and expansion of these liquids during subsequent processes caused blistering or peeling of films. There was the additional problem that liquids remaining in the seam caused corrosion of underlying wiring.

Although various methods of suppressing the occurrence of seams have been investigated (for example, Japanese Patent Laid-open No. 326436/1997), absolute suppression of the occurrence of seams has proved difficult. Suppressing the occurrence of seams in all of a plurality of via-holes formed on a wafer is particularly difficult.

Defects may also occur in the formation of a conductive film inside a via-hole before the occurrence of a seam. For example, in the process of embedding a CVD-tungsten film inside a via-hole having a diameter of 0.2 ^{■} or less, the tungsten may be deposited in an overhanging state at the upper portion of the hole and thus cause a void-shaped cavity to occur inside the hole. In such a case, problems such as blistering or peeling of a film or corrosion of wiring may occur as in the case of the occurrence of a seam.

The foregoing explanation underlines the importance of developing both a technique for suppressing the occurrence of cavities such as seams or voids and a process that does not adversely affect the quality of wiring structures despite the occurrence of cavities in order to obtain a wiring structure having high reliability.

### Summary of the Invention:

An object of the present invention is to provide such a process and a method that prevents blistering of a film or peeling of a film in cases in which CMP polishing solution, rinsing solution, or resist removing solution is present inside a cavity and that enables the fabrication of high-quality semiconductor devices at high product yield.

The first method of the present invention that solves the above-described problems is as follows:

An interlayer dielectric film is formed on a semiconductor substrate, following which a depression is formed in the interlayer dielectric film.

A first conductive film is embedded in the depression by depositing a conductive material over the entire surface of the interlayer dielectric film so as to bury the depression and then removing the conductive material from areas other than the depression.

A heat treatment is performed to dry the interior of cavities that have occurred in the first conductive film.

A second conductive film is formed that contacts the upper surface of the first conductive film.

The second method of the present invention is as follows:

Lower-layer wiring is formed on a dielectric film that is provided on a semiconductor substrate, following which an interlayer dielectric film is formed over the entire surface of the lower-layer wiring and the dielectric film.

Connection holes are provided in the interlayer dielectric film that reach the lower-layer wiring and a metal film is formed over the entire surface of the interlayer dielectric film, following which the metal film is removed until the surface of the interlayer dielectric film is exposed to form wiring plugs inside the connection holes.

A heat treatment is performed to dry the interior of cavities that have occurred in the wiring plugs.

Upper-layer wiring is formed that connects to the wiring plugs.

As described hereinabove, when forming plugs that connect between wiring, seams conventionally tend to occur in the embedded portion of the plugs, and these seams may cause blistering or peeling of films. As a countermeasure, according to the method of the present invention as described hereinabove, the interiors of the cavities of seams or voids that have occurred in a conductive film of interlayer connection plugs or damascene wiring are first dried before forming another overlying film. As a result, the occurrence of blistering or peeling of a film due to the expansion of liquids such as CMP processing solution or resist removing solution that are present inside the cavities can be prevented. The method of the present invention can further prevent problems such as the corrosion of an underlying conductive film by liquid that remains inside a seam. Finally, the method of the present invention enables fabrication of high-quality semiconductor devices at good product yield.

The third method of the present invention is as follows:

A first conductive film is formed on a semiconductor substrate, an interlayer dielectric film is formed on this first conductive film, following which a first depression is formed in the interlayer dielectric film.

A second conductive film is embedded inside the depression by depositing a conductive material over the entire surface of the interlayer dielectric film so as to bury the first depression and then removing the deposited conductive material in areas other than the depression.

A dielectric material is applied to cavities that have occurred in the second conductive film and to the upper portion of the second conductive film using a rotational application method and then dried to form a dielectric film.

The dielectric film is etched to form a second depression in which the second conductive film is exposed at the bottom, following which a third conductive film is formed to bury the second depression.

The fourth method of the present invention is as follows:

Lower-layer wiring is formed on a dielectric film that is provided on a semiconductor substrate, following which an interlayer dielectric film is formed over the entire surface of the lower-layer wiring and the dielectric film.

Connection holes that reach to the lower-layer wiring are provided in the interlayer dielectric film and a metal film is formed over the entire surface of the interlayer dielectric film, following which the metal film is removed until the surface of the interlayer dielectric film is exposed to form wiring plugs in the connection holes.

A dielectric material is applied to cavities that occur in the wiring plugs and to the upper portion of the wiring plugs using a rotational application method and then dried to form a dielectric film.

The dielectric film is etched to form wiring trenches in which the wiring plugs are exposed at the bottom, following which upper-layer wiring is formed to bury the wiring trenches.

In the above-described methods, embedding dielectric material inside cavities allows the use of a removing solution having strong removing action without causing damage to the first conductive layer or to lower-layer wiring and thus allows etching deposits to be effectively removed while preventing an increase in resistance. A rotational application dielectric material, i.e., a material that allows a solution that contains a dielectric film material to be applied by rotational application method, is preferably used as the dielectric material in these methods.

The semiconductor device of the present invention is provided with a first conductive film and a second conductive film that is formed in contact with the upper surface of the first conductive film on a semiconductor substrate, wherein a dielectric material is embedded in cavities in the first conductive film.

Another semiconductor device of the present invention is provided with lower-layer wiring that is formed on a semiconductor substrate, upper-layer wiring that is formed over the lower-layer wiring, and wiring plugs that connect the wiring, wherein a dielectric material is embedded in cavities in the wiring plugs.

In the above-described configuration, embedding dielectric material inside cavities can prevent the penetration of chemical solutions that are used in various fabrication steps into the cavities, and can prevent damage at locations where cavities occur and to an underlying conductive film. The present invention therefore can realize a semiconductor device having greater reliability and with higher productivity than the prior art. A rotational application material, i.e., a material that allows a solution containing a dielectric film material to be applied by rotational application method, is preferably used as the dielectric material.

An inorganic polysiloxane such as HSQ, a polyorganosiloxane such as MHSQ or MSQ (methyl silisesquioxane), or an aromatic organic resin such as polyarylene ether (PAE) or divinyl siloxane-bis-benzocyclobutene (BCB) can be used as the rotational application material. These materials allow rotational application method, and in addition, have a low dielectric constant and can effectively reduce interwiring crosstalk.

The above and other objects, features, and advantages of the present invention will become apparent from the following description with respect to the accompanying drawings which illustrate examples of the present invention.

### Brief Description of the Drawings:

Figs. 1A-1D show a semiconductor device fabrication method according to the first example of the prior art;
Figs. 2A-2B show a semiconductor device fabrication method according to the first example of the prior art;
Figs. 3A-3C show a semiconductor device fabrication method according to the first example of the prior art;
Figs. 4A-4C show a semiconductor device fabrication method according to the first example of the prior art;
Figs. 5 shows a semiconductor device fabrication method according to the first example of the prior art;
Figs. 6A-6C show a semiconductor device fabrication method according to the second example of the prior art;
Fig. 7 shows a semiconductor device fabrication method according to the second example of the prior art;
Figs. 8A-8B show a semiconductor device fabrication method according to the second example of the prior art;
Figs. 9A-9D show the semiconductor device fabrication method according to the first embodiment of the present invention;
Figs. 10A-10B show the semiconductor device fabrication method according to the first embodiment of the present invention;
Figs. 11A-11C show the semiconductor device fabrication method according to the first embodiment of the present invention;
Figs. 12A-12C show the semiconductor device fabrication method according to the first embodiment of the present invention;
Figs. 13A-13D show the semiconductor device fabrication method according to the second embodiment of the present invention;
Figs. 14A-14B show the semiconductor device fabrication method according to the second embodiment of the present invention;
Fig. 15 shows the semiconductor device fabrication method according to the second embodiment of the present invention;
Figs. 16A-16C show the semiconductor device fabrication method according to the second embodiment of the present invention;
Figs. 17A-17C show the semiconductor device fabrication method according to the second embodiment of the present invention;
Figs. 18A-18C show the semiconductor device fabrication method according to the third embodiment of the present invention;
Figs. 19A-19B show the semiconductor device fabrication method according to the third embodiment of the present invention;
Fig. 20 is a schematic view of the two-layer wiring structure used in the appraisal of working examples of the present invention and comparative examples;
Fig. 21 shows the results of measuring chain resistance in working examples of the present invention; and
Fig. 22 shows the results of measuring chain resistance in the comparative examples.

### Detailed Description of the Preferred Embodiments:

The semiconductor device fabrication method of the present invention can take the form of, for example, a method including the following steps.
(a) a step of forming a first conductive film on a semiconductor substrate, forming an interlayer dielectric film on the first conductive film, and then forming a first depression in the interlayer dielectric film
(b) a step of embedding a metal film in the first depression by depositing a metal material over the entire surface of the interlayer dielectric film so as to bury the first depression and then removing the deposited metal material in areas other than the first depression
(c) a step of forming a dielectric film over the entire area over the metal film
(d) a step of forming a resist film having an opening over the dielectric film
(e) a step of etching the dielectric film using the resist film as a mask to form a second depression in which the metal film is exposed at the bottom
(f) a step of performing a process using a resist removing solution to remove the resist film
(g) a step of forming a second conductive film so as to bury the second depression
(h) a drying step carried out by a heat treatment to dry the interiors of cavities that occur in the metal film at any of the steps from step (b) through step (g).

In this fabrication method, cavities may be buried by a rotational application dielectric material following the drying step.

Step (b) may be realized by Chemical Mechanical Polishing (CMP). The first, second, and third conductive films may be, for example, the following parts:
First conductive film: lower-layer wiring
Second conductive film: connection plugs
Third conductive film: upper-layer wiring

In this case, the lower-layer wiring and upper-layer wiring may be composed by copper or a copper alloy, and the connection plugs may be composed by tungsten.
In addition, the first, second, and third conductive films may each be wiring films that are formed by a dual-damascene method.

The method of forming the first, second, and third conductive films is not specifically limited, but is preferably a film formation method that enables films to be effectively embedded. The second conductive film is preferably formed by CVD.

The drying step is preferably performed between Step (b) and Step (c), or between Step (f) and Step (g). If the drying step is performed between Steps (b) and (c), fluids (CMP polishing solution or rinse solution) used in Step (b) that remain inside cavities of the second conductive film can be vaporized. If the drying step is performed between Steps (f) and (g), resist removing solution that remains inside cavities of the second conductive film can be vaporized. Because remaining resist removing solution can bring about such adverse effects as damage to the first conductive film, the employment of the drying step between Steps (f) and (g) is particularly effective.

Preferable embodiments of the present invention are next described.

### [First Embodiment]

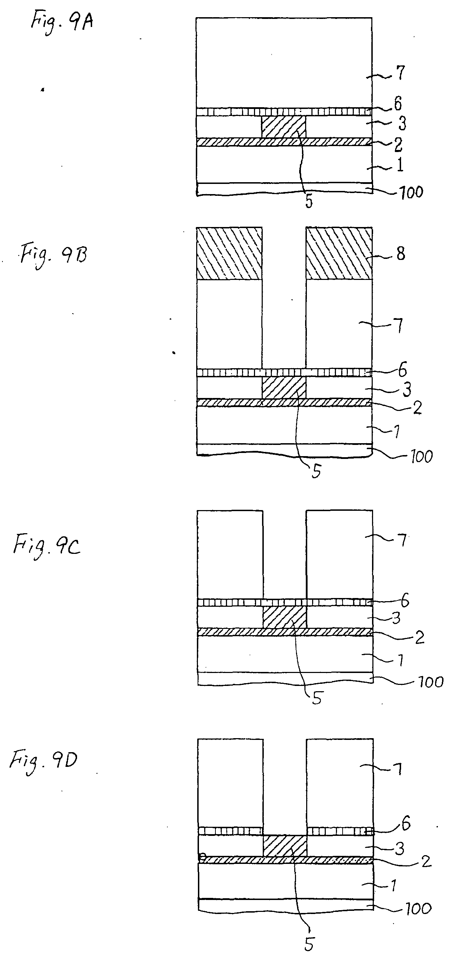

As shown in Fig. 9A, damascene copper wiring is first formed.

Specifically, silicon oxide film 1, silicon oxynitride film 2, and silicon oxide film 3 are formed by, for example, plasma CVD on a semiconductor substrate 100 on which transistors (not shown) have been formed. Copper film 5 is then embedded in silicon oxide film 3 by a known damascene method to form the copper wiring. Next, silicon nitride film 6 and silicon oxide film 7 are formed over silicon oxide film 3 and copper film 5 by, for example, a plasma CVD method.

Resist film 8 having a prescribed opening is next provided on silicon oxide film 7, and using this resist film 8 as a mask, silicon oxide film 7 is subjected to dry etching to form a via-hole that reaches as far as silicon nitride film 6 (Fig. 9B).

To remove resist film 8, oxygen plasma ashing is carried out, following which resist residue that adheres to the surface of silicon oxide film 7 and to the inner walls of the hole is removed by a resist removing solution (Fig. 9C). Silicon nitride film 6 is next subjected to dry etching to expose the surface of copper film 5, following which the resist residue is removed by a resist removing solution (Fig. 9D).

Next, an adhesive film (not shown in the figure) is formed over the entire surface of silicon oxide film 7. The adhesive film is formed to strengthen adhesion between tungsten and the inner walls of the via-hole, and may be a film in which, for example, a titanium film and a titanium nitride are laminated in that order. The titanium film is formed by a sputtering and may have a thickness of, for example, 20-50 nm. The titanium nitride film is formed by, for example, a reactive sputtering and has a thickness of, for example, 20-50 nm. The adhesive film that is composed of these films strengthen adhesion between the interlayer dielectric film and the tungsten film that is formed in the next step.

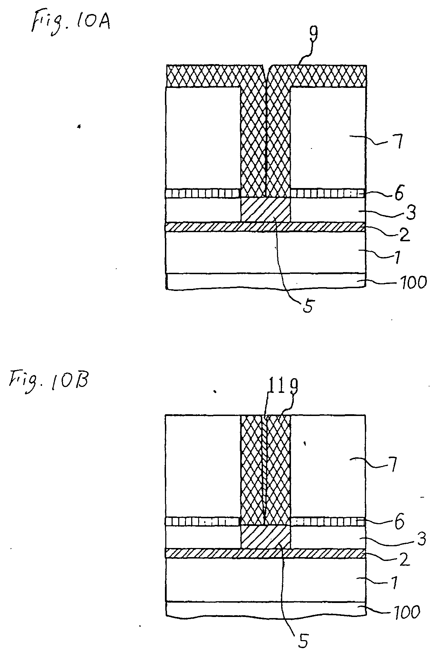

Tungsten film 9 is then formed by CVD on the adhesive film (Fig. 10A). The material gas when forming the film is, for example, a gas containing WF₆. The interior of the via-hole is thus buried by tungsten. Tungsten film 9 can be formed in a variety of CVD conditions. For example, tungsten film 9 can be formed by first lightly forming tungsten micro-crystals, which are the nuclei for forming a high-density CVD tungsten film, on the inner surfaces of the hole and growing the crystals by low-pressure CVD (growth nucleus formation step), and then carrying out a bulk tungsten film formation step. Although a tungsten film that is relatively well-suited for embedding can be formed by adopting this type of film formation process, complete suppression of the occurrence of seams is difficult.

After forming tungsten film 9, CMP is carried out using a slurry containing an oxidizing agent and an abrasive, followed by rinsing with pure water. Excess tungsten film 9 that has formed outside the hole is thus removed and a via-plug composed of tungsten film 9 inside the via-hole is formed (Fig. 10B). At this time, CMP processing solution 11 that is made up by CMP polishing solution and rinse solution penetrates the seams that have occurred in tungsten film 9.

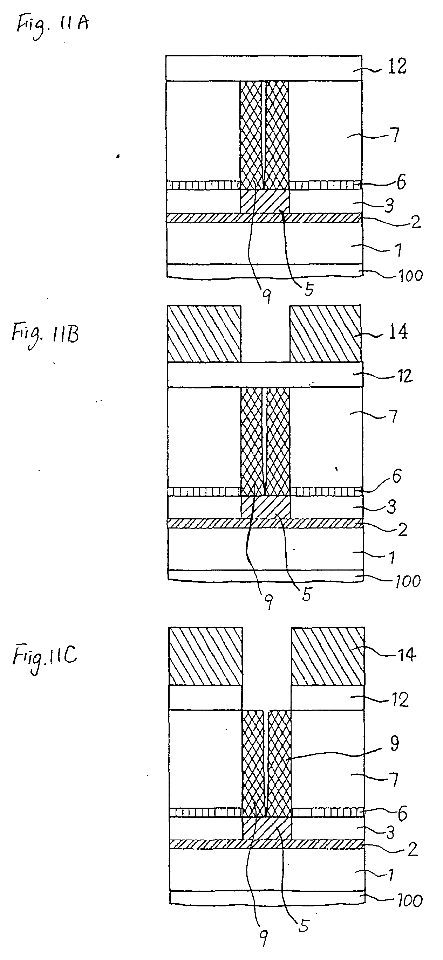

Silicon oxide film 12 is next formed on tungsten film 9 (Fig. 11A). Silicon oxide film 12 is formed by plasma CVD using, for example, monosilane or TEOS (tetraethoxysilane) as the material gas. Although silicon oxide film 12 is formed directly on tungsten film 9 in the present embodiment, a silicon nitride film may be interposed between these films. After forming silicon oxide film 12, resist film 14 having prescribed openings is provided (Fig. 11B), and wiring trenches are formed in silicon oxide film 12 using this resist film 14 as a mask (Fig. 11C).

Oxygen plasma ashing and processing by an amine removing solution are next carried out to remove resist film 14 and the etching residue.

After the resist has been removed, amine removing solution 15 penetrates the seam in the tungsten film as shown in Fig. 12A.

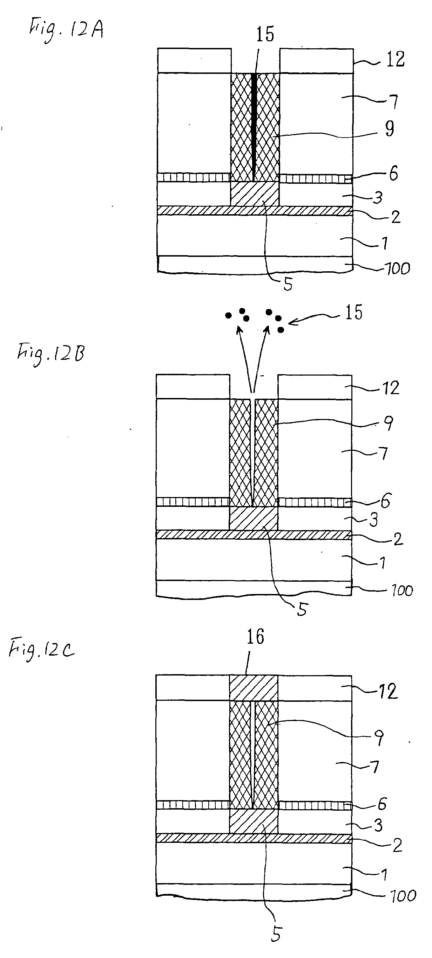

A heat treatment is carried out to vaporize this amine removing solution 15 (Fig. 12B). The temperature of the heat treatment is preferably 200-450°C, and more preferably 350-450°C. If the temperature of the heat treatment is too low, removing solution will remain, and this will give rise to blistering or peeling of the wiring that is formed on the tungsten plug and cause damage to the wiring composed of copper film 5. Making the temperature of the heat treatment too high, on the other hand, may affect the distribution of the impurity diffusion layer or adversely affect element performance. In addition, the duration of the heat treatment is preferably greater than one minute, and more preferably greater than 10 minutes. The interiors of seams can thus be dried sufficiently. Although there is no particular limitation on the maximum duration, a process of 30 minutes or less is sufficient. Examples of preferable heat treatment conditions are given below:
(i) Heat Treatment Condition 1
   Treatment temperature: 400-450°C
   Treatment duration: 10-20 minutes
   Treatment atmosphere: Inert gas (argon, nitrogen, etc.) at atmospheric pressure
(ii) Heat Treatment Condition 2
   Treatment temperature: 200-300°C
   Treatment duration: 30 seconds - 1 minute
   Treatment atmosphere: 3-20 mtorr vacuum

It has been confirmed that the seam interior can be more adequately dried using the conditions in case (i). Copper film 16 is then embedded in the wiring trenches by a known damascene process to form damascene copper wiring (Fig. 12C). According to the processes shown in the present embodiment, seam interiors are sufficiently dried by the heat treatment of Fig. 12B, and the occurrence of blistering in copper film 16 that is formed above the seam can therefore be suppressed and a wiring structure of higher reliability can be formed at a high product yield.

### [Second Embodiment]

This embodiment is a case in which HSQ, which is one type of rotational application dielectric material, is used as the material of the interlayer dielectric film of the copper wiring layers.

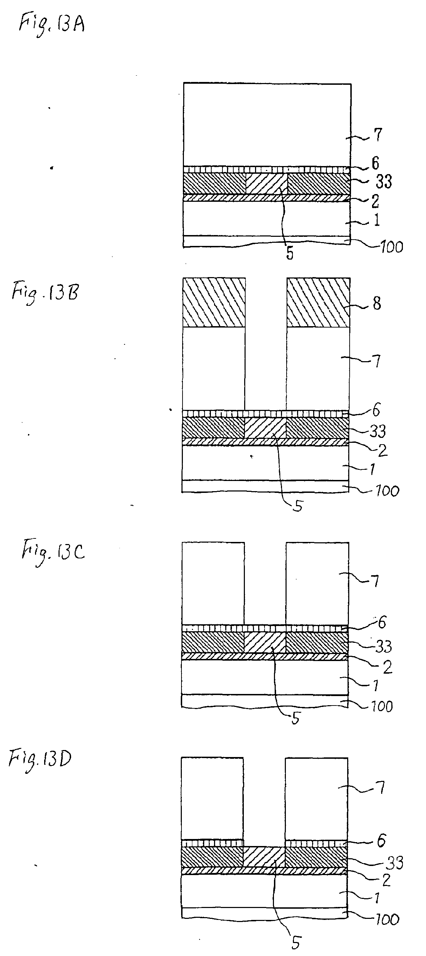

The steps shown in Figs. 13A-14B are first carried out similarly to the steps shown in Figs. 9A-10B of the first embodiment with the exception that silicon oxide film 3 is replaced by HSQ film 33.

In other words, silicon oxide film 1, silicon oxynitride film 2, HSQ film 33, and copper film 5 are formed on a semiconductor substrate to form damascene copper wiring, following which tungsten film 9 is formed inside a via-hole in silicon nitride film 6 and silicon oxide film 7 so as to contact the copper wiring. HSQ 33 is formed by a rotational application method. In this embodiment, the film is formed by applying, to the surface of a wafer that is rotating at a prescribed speed, a solution containing the HSQ film material as a liquid, and then carrying out a multi-stage heat treatment. An example of the conditions for rotational application method is as follows:
Application temperature: room temperature
   (approximately 25°C)
Applied material: HSQ solution
Rotational speed of wafer at time of application:
   1500 rpm (one-stage application)
Heat treatment conditions: Three-stage curing at 80°C, 100°C, and 120°C

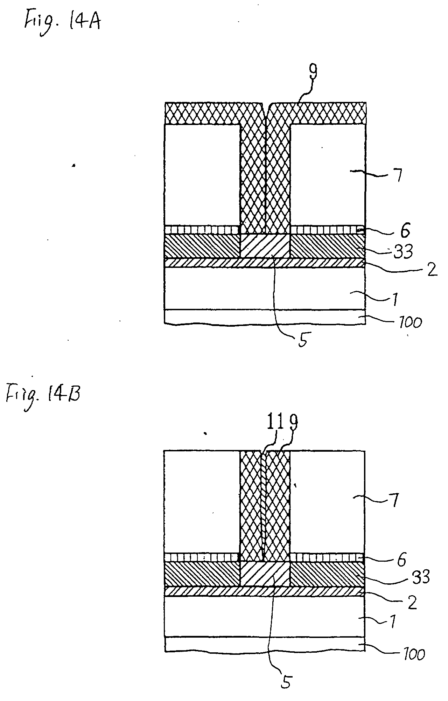

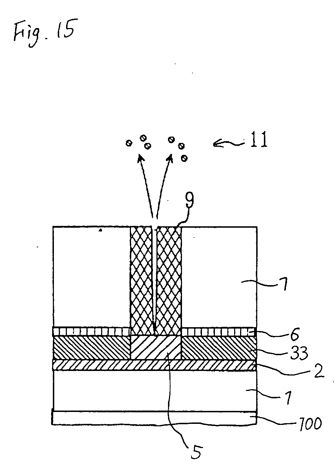

Employing HSQ film 33, which has a low dielectric constant, as the dielectric film of the copper wiring layer suppresses the occurrence of interwiring crosstalk and improves the high-speed operation of the elements.
After forming a via-plug that is composed of tungsten film 9 and an adhesive film (not shown in the figure) inside the via-hole as shown in Fig. 14B by proceeding through the steps of Figs. 13A-14B, a heat treatment is carried out to vaporize CMP process solution 11 composed of the CMP polishing solution and rinse solution that has entered the seam (Fig. 15). The temperature of the heat treatment is preferably 200-450°C, and more preferably 350-450°C. If the treatment temperature is too low, removing solution will remain and give rise to blistering and peeling of the wiring that is formed over the tungsten plug and cause damage to the copper wiring. Making the treatment temperature too high, on the other hand, may affect the distribution of the impurity diffusion layer and adversely affect the performance of elements. In addition, the duration of the heat treatment is preferably one minute or greater, and more preferably 10 minutes or greater. The seam interior can thus be adequately dried. Although there is no limitation on the maximum duration, a process of 30 minutes or less is adequate. Examples of preferable heat treatment conditions are shown below:
(i) Heat Treatment Condition 1
   Treatment temperature: 400-450°C
   Treatment duration: 10-20 minutes
   Treatment atmosphere: Inert gas (argon, nitrogen, etc) at atmospheric pressure
(ii) Heat Treatment Condition 2
   Treatment temperature: 200-300°C
   Treatment duration: 30 seconds - 1 minute
   Treatment atmosphere: 3-20 mtorr vacuum

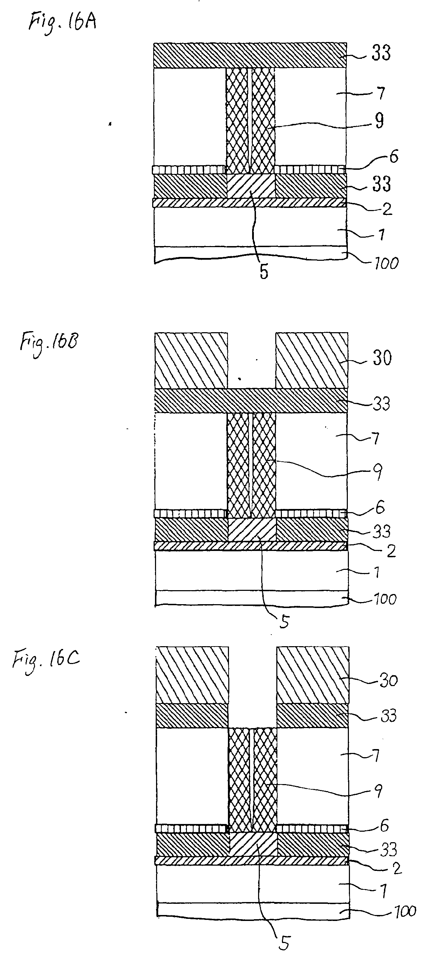

It has been confirmed that the seam interior can be more adequately dried using the conditions in case (i).
HSQ film 33 is next formed directly on tungsten film 9 by a rotational application method (Fig. 16A). HSQ film 33 is formed by a rotational application method. An example of the conditions for rotational application method is as follows:
Application temperature: room temperature
   (approximately 25°C)
Applied material: HSQ solution
Rotational speed of wafer at time of application:
   1500 rpm (one-stage application)
Heat treatment conditions: Three-stage curing at 80°C, 100°C, and 120°C

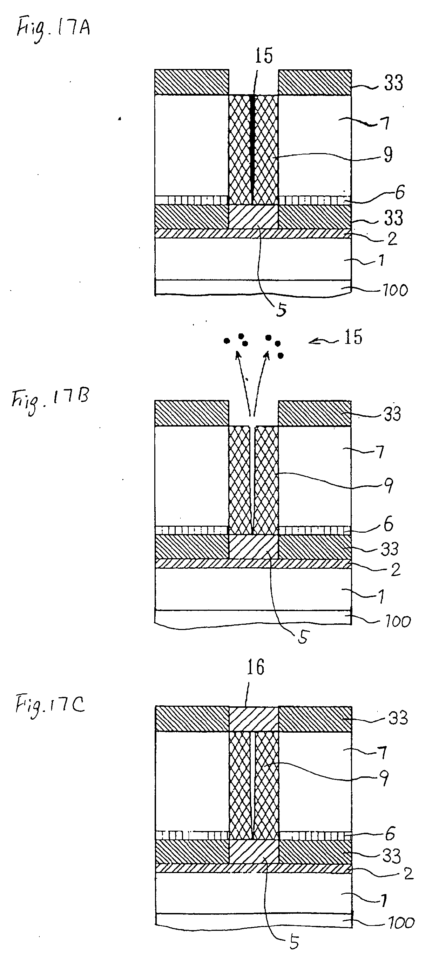

The steps shown in Figs. 16B-17C are next carried out similar to the steps shown in Figs. 11B-12C of the first embodiment. At the stage of Fig. 17B, a heat treatment is carried out to vaporize amine removing solution 15. The preferable heat treatment conditions are the same as those described in the explanation of Fig. 12B. The wiring structure is formed by proceeding through the above-described steps.

Although the use of a rotationally applied film such as HSQ as the dielectric film of the wiring layer can both suppress the occurrence of crosstalk and improve flatness, the temperature of film formation is close to room temperature and chemical solutions such as the CMP process solutions therefore tend to remain in seams. A heat treatment is therefore performed before forming the HSQ film over the tungsten plug in the present embodiment.
According to the processes shown in this embodiment, seam interiors are adequately dried by a heat treatment and the occurrence of blistering in the overlying HSQ film or copper film can therefore be suppressed, whereby a wiring structure having high reliability can be formed with good product yield.

### [Third Embodiment]

This embodiment is a case in which methyl hydrogen silisesquioxane (hereinbelow referred to as "MHSQ"), which is one type of rotationally applied film material, is used as the material of the interlayer dielectric film of the copper wiring layers. The present embodiment is a process similar to the second embodiment but differs in that an ammonium fluoride removing solution having a strong removing action is employed as the resist removing solution and a film having a low dielectric constant is caused to partially enter the seams.

First, steps are performed similar to those of Figs. 13A-14B in the second embodiment. In other words, silicon oxide film 1, silicon oxynitride film 2, MHSQ film 17, and copper film 5 are formed on a semiconductor substrate to form damascene copper wiring, following which tungsten film 9 is formed in via-holes in silicon nitride film 6 and silicon oxide film 7 so as to contact the copper wiring. MHSQ film 17 is formed by a rotational application method. The conditions of this film formation are shown below:
Application temperature: room temperature
   (approximately 25°C)
Applied material: MHSQ solution
Rotational speed of wafer at time of application:
   1500 rpm (one-stage application)
Heat treatment conditions: Three-stage curing at 80°C, 100°C, and 120°C

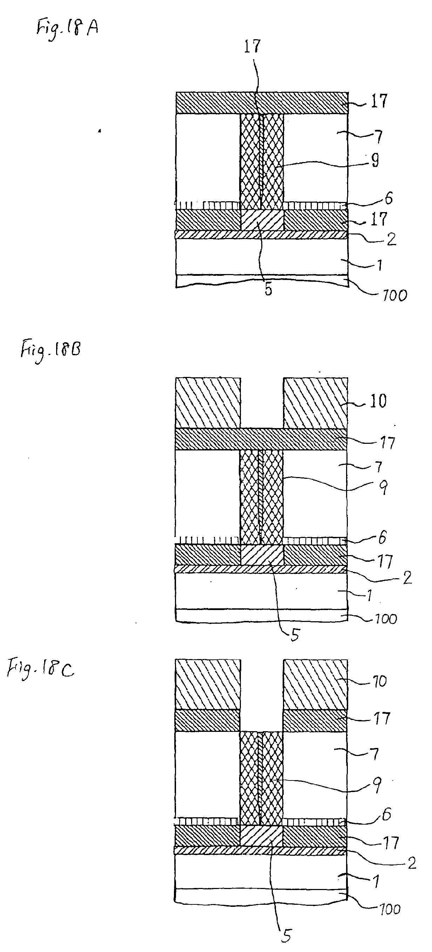

After carrying out a heat treatment to vaporize CMP process solution 11 that has entered seams, MHSQ film 17 is formed directly on tungsten film 9 (Fig. 18A). MHSQ film 17 is formed by a rotational application method, and conditions are selected such that MHSQ material enters the seams. For this purpose, it is effective to carry out a first application while rotating the wafer at a low speed and then carrying out a second application while rotating the wafer at a high speed. An example of these rotational application conditions is shown below:
Application temperature: room temperature
   (approximately 25°C)
Applied material: MHSQ solution
Rotational speed of wafer at time of application:
   (1) 150 rpm
   (2) 1500 rpm
      (two-stage application)
Heat treatment conditions: Three-stage curing at 80°C, 100°C, and 120°C

For example, by effecting a rotational application under the above-described conditions, MHSQ film can also be embedded inside seams as shown in Fig. 18A.

Resist film 10 is then formed, and using this film as a mask, MHSQ film 17 is dry etched to form wiring trenches (Figs. 18B and 18C). An ashing process and a removing process using ammonium fluoride removing solution are then carried out to remove resist film 10 (Fig. 19A). When etching is carried out to form wiring trenches, etching deposits that are difficult to remove normally adhere to the inner walls of trenches and the side walls of resist film 10. A removing solution having strong removing action is used in this embodiment and these etching deposits can therefore be effectively removed. Furthermore, the embedding of MHSQ film 17 in seams that occur in tungsten film 9 prevents removing solution from reaching and corroding the surface of silicon nitride film 6.

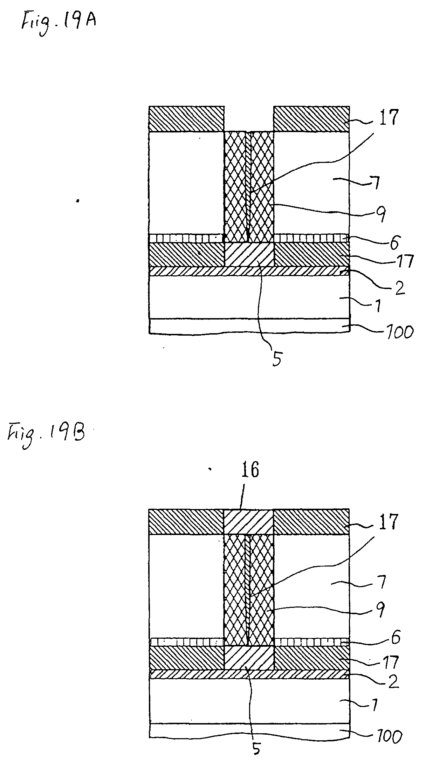

Copper film 16 is then formed inside the wiring trenches provided in MHSQ film 17, and the wiring structure in which lower-layer and upper-layer copper wiring are connected by a tungsten plug is completed (Fig. 19B).

Although employing a rotational application film such as MHSQ as the dielectric film of the wiring layers can obtain such effects as a suppression of the occurrence of crosstalk and an improvement in flatness, chemical solutions tend to remain in seams because the film formation temperature is in the vicinity of room temperature. According to the processes shown in the present embodiment, however, the interiors of seams are effectively dried by heat treatment, thereby suppressing the occurrence of blistering in the MHSQ film or copper film that is formed over seams and enabling the formation of a highly reliable wiring structure at good product yield.

Although the embodiment of the present invention has been explained using an example of the steps for forming a tungsten plug, the present invention can also be applied to steps for forming copper wiring. In other words, the present invention is also effective for vaporizing liquids that remain in seams that occur in copper wiring by a heat treatment and preventing blistering of films that are formed over the seams.

The present invention is also effective when applied to a process that employs copper as the plug material. In particular, plating solution may remain in seams when a copper film is formed by plating, and the process of the present invention can be effectively applied to removing this plating solution.

### [Working Examples 1-3]

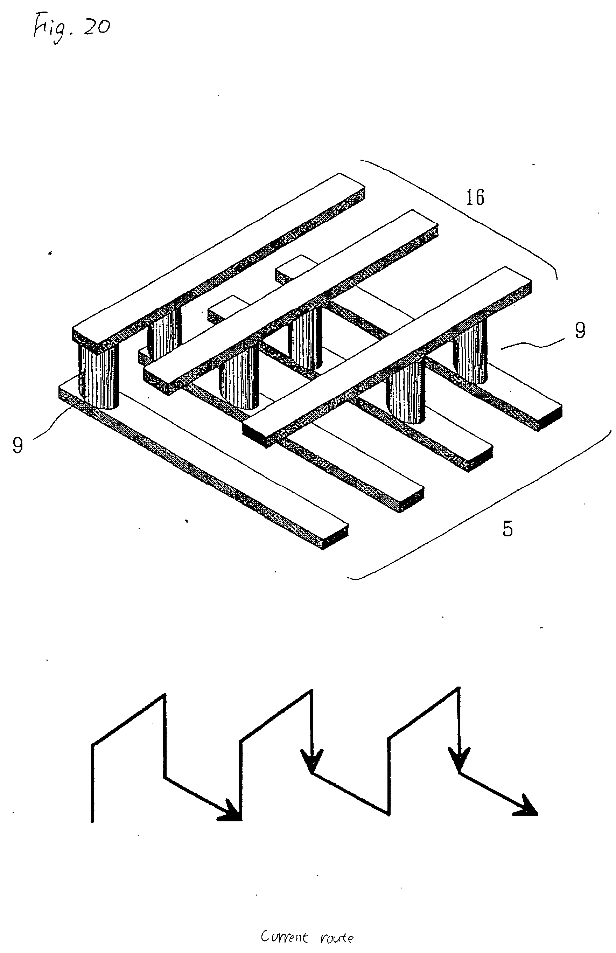

The two-layer wiring structure shown in Fig. 20 was fabricated according to the process described in the third embodiment and a test of reliability was performed. This two-layer wiring structure is referred to as a "via-chain," and is provided with 15,000 parallel lower-layer copper lines made up by copper film 5 and 15,000 parallel upper-layer copper lines made up by copper film 16 that are orthogonal to lower-layer copper lines 5. This wiring is interconnected by 30,000 via-plugs composed of tungsten film 9. In the figure, the semiconductor substrate and interlayer dielectric film have been omitted. When a prescribed voltage is applied to two ends of this via-chain, a current flows in the direction shown by the arrows in the figure, whereby the electrical resistance though the 15,000 lines of lower-layer wiring, 15,000 lines of upper-layer wiring, and the 30,000 via-plugs can be measured.

The inside diameters of the via-holes were as follows:
Working example 1: 0.22 ^{■}
Working example 2: 0.24 ^{■}
Working example:3: 0.28 ^{■}

In each working example, the dimensions of the plurality of wiring lines and via-plugs were made the same.
The fabrication process of the two-layer wiring structure shown in Fig. 20 is next explained.

Similar to Figs. 13A-14B, silicon oxide film 1, silicon oxynitride film 2, MHSQ film 17 (instead of HSQ film 33), and copper film 5 were formed on a semiconductor substrate to form damascene copper wiring, following which tungsten film 9 was formed in via-holes in silicon nitride film 6 and silicon oxide film 7 so as to connect to the copper wiring. Copper film 5 was formed by a plating process and had a wiring width of 0.3 ^{■} and a wiring thickness of 350 nm. MHSQ film 17 was formed by rotational application method of an MHSQ solution. The MHSQ film formation was performed at room temperature (approximately 25°C), the speed of wafer rotation during application was 1500 rpm (one-stage application), and curing was performed as a three-stage process at 80°C, 100°C, and 120°C.

The conditions for forming the tungsten film that buries the via-plugs were as follows:

### (Growth Nuclei Formation Step)

WF₆ flow: 300 sccm
SiH₄ flow: 100 sccm
Ar flow: 1000 sccm
Substrate temperature: 400°C
Chamber pressure: 300 mtorr

After growing the tungsten film to approximately 50 nm under these conditions, the supply of gas was halted, thereby completing the growth nuclei formation step.

### (Bulk Tungsten Formation Step)

Next, WF₆ and H₂ were supplied to the film formation chamber to form bulk high-density CVD tungsten and the interiors of the holes were buried. This reaction was carried out under H₂ reduction conditions in which the speed of film formation is faster than in the nucleus growing step.

The film formation conditions at this time were as shown below:
WF₆ flow: 100 sccm
H₂ flow: 600 sccm
Ar flow: 1000 sccm
Substrate temperature: 450°C
Chamber pressure: 90 torr

A heat treatment was carried out after the CMP process to vaporize CMP process solution 11 (Fig. 15). The heat treatment conditions were as follows:
Treatment temperature: 400°C
Treatment duration: 10 minutes
Treatment atmosphere: inert gas (argon, nitrogen) at atmospheric pressure

After Fig. 14B, MHSQ film 17 was formed directly on tungsten film 9 by rotational application method (Fig. 18A). MHSQ film 17 was formed by rotational application method. The rotational application conditions were as follows:
Application temperature: room temperature
   (approximately 25°C)
Applied material: MHSQ solution
Rotational speed of wafer at time of application:
   (1) 150 rpm
   (2) 1500 rpm
      (two-stage application)
Heat treatment conditions: Three-stage curing at 80°C, 100°C, and 120°C

Then, after forming resist film 10, MHSQ film 17 was subjected to dry etching using this resist film 10 as a mask to form wiring trenches (Figs. 18B and 18C), following which an ashing process and a removing process using an ammonium fluoride removing solution were carried out to remove resist film 10 (Fig. 19A). Copper film 16 was then formed and CMP was performed to form a wiring structure in which lower-layer and upper-layer copper wiring were connected by tungsten plugs (Fig. 19B).

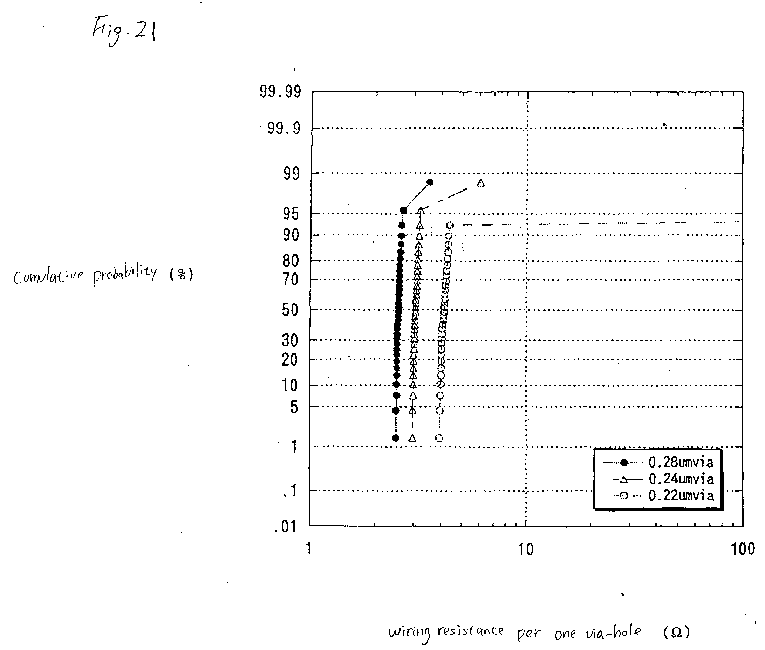

A plurality of chips provided with the wiring structures of working examples 1-3 according to the above-described processes were fabricated and the chain resistance was measured. The results of this test are shown in Fig. 21. In the figure, the horizontal axis shows the wiring resistance per one via-hole, and the vertical axis shows the cumulative probability. All of the wiring structures obtained by the present working examples exhibited low resistance.

### [Comparative Examples]

A two-layer wiring structure shown in Fig. 20 was fabricated in accordance with processes (Figs. 6A-8B) according to the second example of the prior art that was described in the prior art section, and the reliability of the structure was tested. This structure differs from working examples 1-3 in that the step of drying seams was not carried out and silicon oxynitride film 35 was provided over the tungsten plugs. The processes employed were otherwise the same as for working examples 1-3.
In order to maintain correspondence with the working examples, the inner diameters of the via-holes were as follows:
Comparative example 1: 0.22 ^{■}
Comparative example 2: 0.24 ^{■}
Comparative example 3: 0.28 ^{■}

In each of the comparative examples, the dimensions of the plurality of wiring lines and via-plugs were the same.

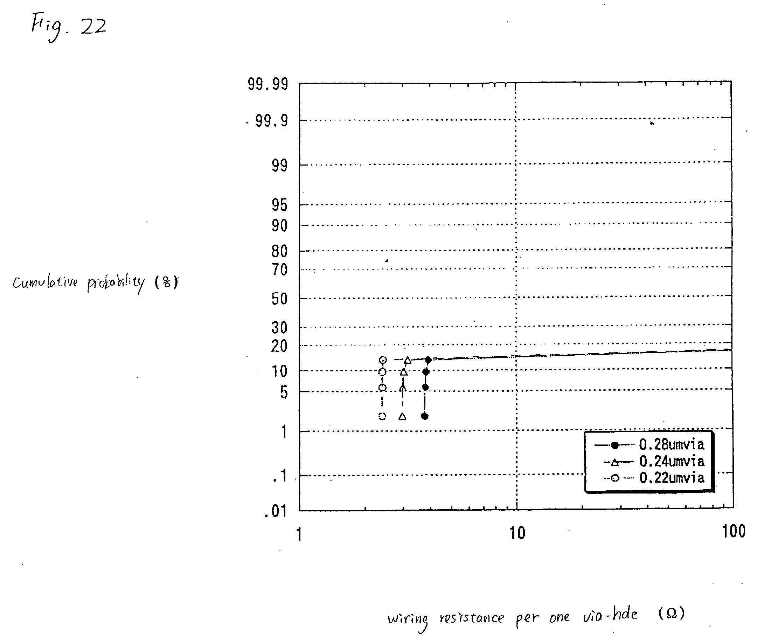

The results of measuring the resistance of the wiring structures of the fabricated comparative examples 1-3 are shown in Fig. 22. All of the comparative examples exhibited high wiring resistance.

Observation of a section of the structure of each comparative example showed that a portion of the lower-layer wiring had dissolved and deteriorated. From this it can be assumed that the increase in wiring resistance is caused by the penetration of removing solution into cavities that occur in tungsten film 9 and the resulting corrosion of the lower-layer wiring. Similar deterioration was not found in working examples 1-3, and this finding affirms that penetration of removing solution was suppressed by the MHSQ film that was embedded in the seams.

While preferred embodiments of the present invention have been described using specific terms, such description is for illustrative purposes only, and it is to be understood that changes and variations may be made without departing from the spirit or scope of the following claims.

## Claims

1. A method of fabricating a semiconductor device comprising steps of:
forming an interlayer dielectric film on a semiconductor substrate and then forming a depression in said interlayer dielectric film;
embedding a first conductive film inside said depression by depositing a conductive material over the entire surface of said interlayer dielectric film so as to bury said depression and then removing the deposited conductive material from areas other than said depression;
performing a heat treatment to dry the interior of cavities that have occurred in said first conductive film; and
forming a second conductive film that contacts the upper surface of said first conductive film.

2. A method of fabricating a semiconductor device comprising steps of:
forming lower-layer wiring on a dielectric film that is provided on a semiconductor substrate and then forming an interlayer dielectric film over the entire surface of said lower-layer wiring and said dielectric film;
providing connection holes in said interlayer dielectric film that reach said lower-layer wiring and forming a metal film over the entire surface of said interlayer dielectric film, and then removing said metal film until the surface of said interlayer dielectric film is exposed to form a wiring plug inside said connection holes;
performing a heat treatment to dry the interior of cavities that have occurred in said wiring plug; and
forming upper-layer wiring that connects to said wiring plug.

3. A method of fabricating a semiconductor device according to claim 2 wherein said lower-layer wiring and said upper-layer wiring are composed of copper or copper alloy, and said wiring plug is composed of tungsten.

4. A method of fabricating a semiconductor device comprising steps of:
forming a first conductive film on a semiconductor substrate, forming an interlayer dielectric film on said first conductive film; and then forming a first depression in said interlayer dielectric film;
embedding a second conductive film inside said first depression by depositing a conductive material over the entire surface of said interlayer dielectric film so as to bury said first depression and then removing deposited conductive material in areas other than said first depression;
applying a dielectric material to cavities that have occurred in said second conductive film and to the upper portion of said second conductive film by a rotational application method, and then drying to form a dielectric film; and
etching said dielectric film to form a second depression in which said second conductive film is exposed at the bottom and then forming a third conductive film to bury said second depression.

5. A method of fabricating a semiconductor device according to claim 4 wherein the interiors of said cavities are dried by a heat treatment after burying said second conductive film and before forming said dielectric film by a rotational application method.

6. A method of fabricating a semiconductor device comprising steps of:
forming lower-layer wiring on a dielectric film that is provided on a semiconductor substrate and then forming an interlayer dielectric film over the entire surface of said lower-layer wiring and said dielectric film;
providing connection holes that reach to said lower-layer wiring in said interlayer dielectric film and forming a metal film over the entire surface of said interlayer dielectric film, and then removing said metal film until the surface of said interlayer dielectric film is exposed to form wiring plugs in said connection holes;
applying a dielectric material to cavities that have occurred in said wiring plugs and to the upper portion of said wiring plugs by a rotational application method, and then drying to form a dielectric film; and
etching said dielectric film to form wiring trenches in which said wiring plugs are exposed at the bottom, and then forming upper-layer wiring to bury said wiring trenches.

7. A method of fabricating a semiconductor device according to claim 6 wherein the interiors of said cavities are dried by a heat treatment after forming said wiring plugs and before forming said dielectric film by a rotational application method.

8. A method of fabricating a semiconductor device according to claim 6 wherein said lower-layer wiring and said upper-layer wiring are composed of copper or a copper alloy, and said wiring plug is composed of tungsten.

9. A method of fabricating a semiconductor device according to claim 7 wherein said lower-layer wiring and said upper-layer wiring are composed of copper or a copper alloy, and said wiring plugs are composed of tungsten.

10. A semiconductor device comprising:
a first conductive film that is formed on a semiconductor substrate,
a second conductive film that is formed to contact the upper surface of said first conductive film, and
a dielectric material that is buried in cavities in said first conductive film.

11. A semiconductor device according to claim 10 wherein said dielectric material is a rotationally applied dielectric material.

12. A semiconductor device comprising:
lower-layer wiring that is formed on a semiconductor substrate,
upper-layer wiring that is formed above said lower-layer wiring,
wiring plugs that connect said lower-layer wiring and said upper-layer wiring, and
dielectric material that is buried in cavities in said wiring plugs.

13. A semiconductor device according to claim 12 wherein said dielectric material is a rotationally applied dielectric material.
